# EUROPÄISCHE PATENTANMELDUNG

(11) **EP 4 102 704 A1**
(43) Veröffentlichungstag der Anmeldung: **14.12.2022**
(21) Anmeldenummer: 22172902.3
(22) Anmeldetag: 12.05.2022
(51) Int. Cl.: H02M 1/12, H02M 1/32, H02M 7/5387

(54) **ANORDNUNG ZUR FUNKTIONSPRÜFUNG VON KONDENSATOREN EINER FILTEREINRICHTUNG EINES FAHRZEUGS**

(30) Priorität: 20.05.2021 DE 102021205150
(71) Anmelder: Siemens Mobility GmbH, 81739 München (DE)
(72) Erfinder: Deumer, Heiko, 47800 Krefeld (DE); Wellner, Andreas, 47803 Krefeld (DE)

(57) **Zusammenfassung**

Die Erfindung betrifft eine Anordnung für ein Fahrzeug, wobei die Anordnung zumindest einen ein- oder mehrphasigen Pulswechselrichter umfasst, der im Betrieb auf Basis einer vorgegebenen internen Taktfrequenz an seiner elektrischen Wechselspannungsseite zumindest eine Ausgangswechselspannung mit einer vorgegebenen Sollfrequenz erzeugt, wobei der Pulswechselrichter in einem Lastbetrieb eine Ausgangswechselspannung mit einer vorgegebenen Lastfrequenz als Sollfrequenz für eine mit dem Pulswechselrichter verbundene ein- oder mehrphasige elektrische Last bereitstellt, und eine zwischen der Wechselspannungsseite des Pulswechselrichters und der Last angeordnete Filtereinrichtung umfasst, wobei die Filtereinrichtung zumindest einen Kondensator umfasst und ausgestaltet ist, zumindest die interne Taktfrequenz des Pulswechselrichters der Ausgangswechselspannung zu filtern. Die Anordnung ist dadurch gekennzeichnet, dass sie ferner eine Kontrolleinrichtung umfasst, wobei die Kontrolleinrichtung ausgestaltet ist, in einem Leerlaufbetrieb des Pulswechselrichters die Sollfrequenz in eine vorgegebene Prüffrequenz zu ändern, wobei die Prüffrequenz höher als die Lastfrequenz ist, zumindest einen bei der Prüffrequenz auf der Wechselspannungsseite des Pulswechselrichters fließenden Leerlaufstrom zu messen, und mittels des zumindest einen Leerlaufstrommesswerts eine korrekte Funktion des zumindest einen Kondensators der Filtereinrichtung zu bestimmen.

## Beschreibung

Die Erfindung bezieht sich auf eine Anordnung für ein Fahrzeug, ein Fahrzeug, insbesondere ein Schienenfahrzeug, umfassend eine solche Anordnung sowie auf Verfahren zum Betreiben einer solchen Anordnung.

Im Bereich der Schienenfahrzeugtechnik werden Pulswechselrichter beispielsweise dazu eingesetzt, eine elektrische Schnittstelle zwischen einem Gleichspannungszwischenkreis und einem Wechselspannungssystem zu bilden, wobei das Wechselspannungssystem insbesondere ein Bordnetz des Fahrzeugs zur Versorgung von beispielsweise Hilfsbetrieben oder elektrische Antriebskomponenten wie insbesondere Antriebsmotoren des Schienenfahrzeugs ist.

Pulswechselrichter arbeiten intern mit einer Taktfrequenz, die höher ist als die Sollfrequenz der auszugebenden Ausgangswechselspannungen. Auf Basis der internen Taktfrequenz werden beispielsweise Leistungshalbleiterschalter des Pulswechselrichters angesteuert. Aufgrund der Taktung des Schaltens dieser Leistungshalbleiterschalter kann sich die interne Taktfrequenz jedoch in den Ausgangswechselspannungen niederschlagen bzw. diese frequenzmäßig in einem unerwünschtem Ausmaße verunreinigen. Daher werden zwischen dem Pulswechselrichter und den von diesem gespeisten elektrischen Lasten üblicherweise Filtereinrichtungen geschaltet. Als Filtereinrichtungen können zum Beispiel so genannte Sinusfilter, bestehend aus Sinusfilter-Induktivitäten und Sinusfilter-Kondensatoren, eingesetzt werden, die eine sinusförmige oder zumindest näherungsweise sinusförmige Ausgangswechselspannung für die angeschlossenen elektrischen Lasten bilden. Bei schnell taktenden Pulswechselrichtern werden im Allgemeinen Sinusfilter-Kondensatoren mit verhältnismäßig kleiner Kapazität angeschlossen.

Der Ausfall einer Filtereinrichtung bzw. eines Sinusfilter-Kondensators einer Filtereinrichtung kann in unterschiedlichen Ausprägungen erfolgen und nachteilig zu schweren Schäden in der gesamten elektrischen Anordnung führen. Zur Gewährleistung der korrekten Funktion einer Filtereinrichtung ist es daher wünschenswert, die Funktion dieser Kondensatoren zuverlässig diagnostizieren bzw. überwachen zu können.

Der Erfindung liegt die Aufgabe zugrunde, eine Anordnung anzugeben, mittels welcher etwaige Fehler in einer Filtereinrichtung in einfacher Weise erkennbar ist.

Diese Aufgabe wird durch eine Anordnung, ein Fahrzeug sowie ein Verfahren mit den jeweiligen Merkmalen der unabhängigen Patentansprüche gelöst. Ausgestaltungen sind in jeweiligen abhängigen Patentansprüchen angegeben.

Ein erster Aspekt der Erfindung betrifft eine Anordnung für ein Fahrzeug, wobei die Anordnung zumindest einen ein- oder mehrphasigen Pulswechselrichter umfasst, der im Betrieb auf Basis einer vorgegebenen internen Taktfrequenz an seiner elektrischen Wechselspannungsseite zumindest eine Ausgangswechselspannung mit einer vorgegebenen Sollfrequenz erzeugt, wobei der Pulswechselrichter in einem Lastbetrieb eine Ausgangswechselspannung mit einer vorgegebenen Lastfrequenz als Sollfrequenz für eine mit dem Pulswechselrichter verbundene ein- oder mehrphasige elektrische Last bereitstellt, und eine zwischen der Wechselspannungsseite des Pulswechselrichters und der Last angeordnete Filtereinrichtung umfasst, wobei die Filtereinrichtung zumindest einen Kondensator umfasst und ausgestaltet ist, zumindest die interne Taktfrequenz des Pulswechselrichters der Ausgangswechselspannung zu filtern. Die Anordnung ist dadurch gekennzeichnet, dass sie ferner eine Kontrolleinrichtung umfasst, wobei die Kontrolleinrichtung ausgestaltet ist, in einem Leerlaufbetrieb des Pulswechselrichters die Sollfrequenz in eine vorgegebene Prüffrequenz zu ändern, wobei die Prüffrequenz höher als die Lastfrequenz ist, zumindest einen bei der Prüffrequenz auf der Wechselspannungsseite des Pulswechselrichters fließenden Leerlaufstrom zu messen, und mittels des zumindest einen Leerlaufstrommesswerts eine korrekte Funktion des zumindest einen Kondensators der Filtereinrichtung zu bestimmen.

Ein Vorteil der erfindungsgemäßen Anordnung besteht darin, dass deren Kontrolleinrichtung einen Prüfbetrieb für die Filtereinrichtung ermöglicht. Die Überwachung beispielsweise der oben erwähnten Sinusfilter-Kondensatoren mit einer jeweils verhältnismäßig kleinen Kapazität ist ohne weitere Maßnahmen im Allgemeinen schwierig, da die am Ausgang des Pulswechselrichters für die Messung von Phasenströmen bereits zur Verfügung stehenden Strommesseinrichtungen üblicherweise für den gesamten Belastungsbereich des Pulswechselrichters, einschließlich sehr großer Ströme, ausgelegt sind, sodass Messungen vergleichsweise kleiner Ströme recht ungenau sind.

Speziell in einem Leerlaufbetrieb des Pulswechselrichters fließen kleine Ströme durch die Filtereinrichtung. Eine Veränderung der Kapazität der Sinusfilter-Kondensatoren lässt sich daher ohne Weiteres nicht immer sicher detektieren, gerade auch dann, wenn in einem Frühstadium eines auftretenden Fehlers sich dieser noch nicht prägnant in den Messsignalen offenbart. Die Erfindung basiert auf der Erkenntnis, dass Fehler in der Filtereinrichtung und speziell von Filterkondensatoren bei niedrigen Frequenzen nur schlecht erkennbar sind, wohingegen höhere Frequenzen aufgrund kleinerer Spannungsabfälle an den Kondensatoren zu größeren, genauer messbaren Strömen führen. Demgemäß ist erfindungsgemäß vorgesehen, im Leerlaufbetrieb des Pulswechselrichters und insbesondere, wenn der Pulswechselrichter von elektrischen Lasten getrennt ist bzw. diese nicht speisen muss, eine höhere Ausgangsfrequenz bzw. Sollfrequenz vorzusehen und dadurch größere Ströme in der Filtereinrichtung hervorzurufen. Die größeren Ströme lassen sich vorteilhaft genauer als kleinere Ströme messen, sodass die Prüfergebnisse bei erhöhter Prüffrequenz besser sind als bei der normalen Lastfrequenz, wie sie für die Speisung von angeschlossenen elektrischen Lasten im Lastbetrieb erforderlich sind.

Einer Weiterbildung der erfindungsgemäßen Anordnung zufolge ist die Kontrolleinrichtung ferner ausgestaltet, im Leerlaufbetrieb des Pulswechselrichters auf eine korrekte Funktion des zumindest einen Kondensators der Filtereinrichtung zu schließen, wenn der Leerlaufstrommesswert in einem vorgegebenen Sollbereich liegt.

Einer weiteren Weiterbildung der erfindungsgemäßen Anordnung zufolge umfasst die Anordnung ferner eine Schalteinrichtung, wobei die Schalteinrichtung in einer elektrischen Verbindung zwischen der Filtereinrichtung und der elektrischen Last angeordnet ist, und wobei die Schalteinrichtung ausgestaltet ist, die Last von dem Pulswechselrichter zu trennen. Ferner ist die Kontrolleinrichtung ausgestaltet, in dem Leerlaufbetrieb des Pulswechselrichters die Sollfrequenz auf die Prüffrequenz zu ändern und den zumindest einen Leerlaufstrommesswert zu bestimmen, wenn die Verbindung mittels der Schalteinrichtung getrennt ist. Dabei kann die Kontrolleinrichtung beispielsweise auf den Leerlaufbetrieb schließen und nach Erkennen des Leerlaufbetriebs die weiteren Schritte durchführen.

Gemäß einer weiteren Weiterbildung umfasst die Anordnung ferner zumindest eine auf der Wechselspannungsseite des Pulswechselrichters angeordnete Strommesseinrichtung, wobei die zumindest eine Strommesseinrichtung im Leerlaufbetrieb den zumindest einen Leerlaufstrommesswert erzeugt.

Gemäß einer auf der vorstehenden Weiterbildung basierenden weiteren Weiterbildung ist die zumindest eine Strommesseinrichtung (70) in einer elektrischen Verbindung zwischen dem Pulswechselrichter (20) und der Filtereinrichtung (60) angeordnet. Vorzugsweise kann die Kontrolleinrichtung dabei im Leerlaufbetrieb als Leerlaufstrommesswerte Strommesswerte derjenigen Strommesseinrichtungen verarbeiten, die auch im Lastbetrieb die Phasenströme auf der Wechselspannungsseite des Pulswechselrichters überwachen. Ferner können die ein oder mehreren Strommesseinrichtungen in der Filtereinrichtung integriert sein bzw. als Teil der Filtereinrichtung ausgestaltet sein.

Gemäß einer weiteren Weiterbildung der Anordnung schließt die Kontrolleinrichtung auf einen Leerlaufbetrieb des Pulswechselrichters, wenn der zumindest eine Leerlaufstrommesswert betragsmäßig einen vorgegebenen Mindestwert erreicht oder diesen unterschreitet.

Einer weiteren Weiterbildung zufolge misst die zumindest eine Strommesseinrichtung einen Kondensatorstrom durch den zumindest einen Kondensator der Filtereinrichtung. Hierzu ist die Strommesseinrichtung vorzugsweise mit dem Kondensator der Filtereinrichtung elektrisch in Reihe geschaltet, um im Leerlaufbetrieb mit dem Leerlaufstrommesswert den jeweiligen Kondensatorstrom durch den Kondensator angeben zu können.

Grundsätzlich können die Kontrolleinrichtung und die Steuereinrichtung als separate Komponenten ausgestaltet sein. Gemäß einer weiteren Weiterbildung ist die Kontrolleinrichtung in eine Steuereinrichtung des Pulswechselrichters integriert. Vorzugsweise wird die Kontrolleinrichtung dabei durch ein in die Steuereinrichtung des Pulswechselrichters integriertes Softwareprogrammmodul gebildet. Eine solche Softwarelösung kann vorteilhaft mit minimalen Zusatzkosten in bekannten Steuereinrichtungen, die zur Ansteuerung von Pulswechselrichtern geeignet sind, implementiert werden.

Die Steuereinrichtung und die Kontrolleinrichtung können ferner als Komponenten des Pulswechselrichters, alternativ jedoch ebenso als separate Komponenten ausgestaltet sein.

Einer weiteren Weiterbildung der Anordnung zufolge weist die Ausgangsspannung des Pulswechselrichters an der elektrischen Wechselspannungsseite im Lastbetrieb eine Sollfrequenz zwischen 1 und 100 Hz auf. Insbesondere kann die Sollfrequenz bzw. Lastfrequenz 50 oder 60 Hz betragen. Die interne Taktfrequenz des Pulswechselrichters ist nach der Weiterbildung mindestens zehnmal höher als die Lastfrequenz. Sie kann dabei vorzugsweise in einem Bereich zwischen 1 kHz und 100 kHz liegen. Die Ausgangsspannung des Pulswechselrichters weist an der elektrischen Wechselspannungsseite im Leerlaufbetrieb vorzugsweise eine Sollfrequenz bzw. Leerlauffrequenz auf, die zwischen dem 1,5-fachen und 2,5-fachen der Lastfrequenz liegt.

Ein zweiter Aspekt der Erfindung betrifft ein Fahrzeug, welches zumindest eine der vorstehend beschriebenen Anordnungen aufweist. Bezüglich der Vorteile des erfindungsgemäßen Fahrzeugs sowie vorteilhafter Ausgestaltungen des erfindungsgemäßen Fahrzeugs sei auf die obigen Ausführungen im Zusammenhang mit der erfindungsgemäßen Anordnung und deren vorteilhafter Ausgestaltungen verwiesen.

Gemäß einer Weiterbildung weist das Fahrzeug einen Gleichspannungszwischenkreis auf, der mit einer elektrischen Gleichspannungsseite des Pulswechselrichters verbunden ist, und ist als elektrische Last eine Antriebskomponente oder ein Bordnetz des Fahrzeugs von dem Gleichspannungszwischenkreis mit elektrischer Energie speisbar. Eine Prüfung der Filtereinrichtung erfolgt dabei vorzugsweise, wenn die Last von dem Pulswechselrichter getrennt ist.

Gemäß einer weiteren Weiterbildung ist das Fahrzeug als ein Schienenfahrzeug ausgestaltet. Ein solches Schienenfahrzeug ist dabei als eine Lokomotive oder als ein Triebzug, insbesondere für eine Fahrgastbeförderung im Nah-, Regional- oder Fernverkehr, ausgestaltet.

Ein dritter Aspekt der Erfindung betrifft ein Verfahren zum Betreiben einer Anordnung für ein Fahrzeug, wobei die Anordnung einen ein- oder mehrphasigen Pulswechselrichters umfasst und wobei der Pulswechselrichter auf Basis einer vorgegebenen internen Taktfrequenz an einer elektrischen Wechselspannungsseite zumindest eine Ausgangswechselspannung mit einer vorgegebenen Sollfrequenz erzeugt, wobei von dem Pulswechselrichter in einem Lastbetrieb eine Ausgangswechselspannung mit einer vorgegebenen Lastfrequenz als Sollfrequenz für eine mit dem Pulswechselrichter verbundene ein- oder mehrphasige elektrische Last bereitgestellt wird, und wobei mittels einer zwischen der elektrischen Wechselspannungsseite des Pulswechselrichters und der Last angeordneten Filtereinrichtung zumindest die interne Taktfrequenz des Pulswechselrichters gefiltert wird. Das Verfahren ist dadurch gekennzeichnet, dass in einem Leerlaufbetrieb des Pulswechselrichters von einer Kontrolleinrichtung der Anordnung die Sollfrequenz in eine Prüffrequenz geändert wird, wobei die Prüffrequenz höher als die Lastfrequenz ist, zumindest ein bei der Prüffrequenz auf der Wechselspannungsseite des Pulswechselrichters fließender Leerlaufstrom gemessen wird, und mittels des zumindest einen Leerlaufstrommesswerts eine korrekte Funktion des zumindest einen Kondensators der Filtereinrichtung bestimmt wird.

Erfindungsgemäß ist bezüglich eines solchen Verfahrens vorgesehen, dass im Falle eines Leerlaufbetriebs des Pulswechselrichters als Sollfrequenz eine verglichen mit der Lastfrequenz höhere Prüffrequenz erzeugt wird und anhand zumindest eines Leerlaufstrommesswerts, der den Stromfluss auf der Wechselspannungsseite des Pulswechselrichters bei der höheren Prüffrequenz anzeigt, die korrekte Funktion der Filtereinrichtung bzw. des einen oder der mehreren Kondensatoren überprüft wird.

Gemäß einer Weiterbildung des Verfahrens ist eine Schalteinrichtung der Anordnung in einer elektrischen Verbindung zwischen der Filtereinrichtung und der elektrischen Last angeordnet, wobei von der Schalteinrichtung die Last von dem Pulswechselrichter getrennt wird, und werden von der Kontrolleinrichtung auf den Leerlaufbetrieb des Pulswechselrichters geschlossen, die Sollfrequenz auf die Prüffrequenz geändert und der zumindest eine Leerlaufstrommesswert bestimmt, wenn die Verbindung mittels der Schalteinrichtung getrennt ist.

Einer weiteren Weiterbildung des Verfahrens zufolge wird bei einem mehrphasigen Pulswechselrichter und einer Filtereinrichtung mit zumindest einem Kondensator je Phase der Ausgangswechselspannung die korrekte Funktion der Kondensatoren mittels eines Vergleichs der Leerlaufstrommesswerte bestimmt.

Die Erfindung wird nachfolgend anhand von Ausführungsbeispielen näher erläutert; dabei zeigen beispielhaft:
- Figur 1: ein Ausführungsbeispiel für ein Schienenfahrzeug, das mit einem Pulswechselrichter ausgestattet ist, wobei der Pulswechselrichter im Lastbetrieb betrieben wird,
- Figur 2: das Ausführungsbeispiel gemäß Figur 1, wobei der Pulswechselrichter im Leerlaufbetrieb betrieben wird,
- Figur 3: ein Ausführungsbeispiel für ein Schienenfahrzeug, bei dem eine Strommesseinrichtung in einer Filtereinrichtung integriert ist, und
- Figur 4: ein Ausführungsbeispiel für ein Schienenfahrzeug, bei dem eine Strommesseinrichtung in dem Pulswechselrichter integriert ist.

In den Figuren werden für identische oder vergleichbare Komponenten dieselben Bezugszeichen verwendet.

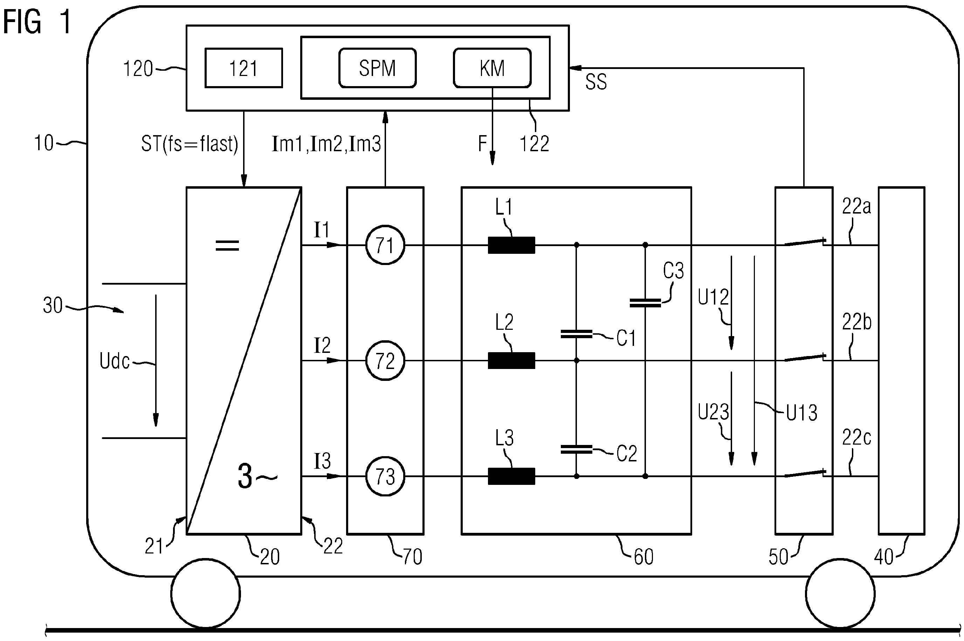

Die Figur 1 zeigt ein Ausführungsbeispiel für ein Schienenfahrzeug 10, das mit einem Pulswechselrichter 20 ausgestattet ist. Eine Gleichspannungsseite 21 des Pulswechselrichters 20 steht mit einem Gleichspannungszwischenkreis 30 des Schienenfahrzeugs 10 in Verbindung und ist mit einer Gleichspannung Udc beaufschlagt. Eine Wechselspannungsseite 22 des Pulswechselrichters ist an ein dreiphasiges Wechselspannungssystem angeschlossen, das drei Phasenleiter 22a, 22b und 22c umfasst.

An die drei Phasenleiter 22a, 22b und 22c ist eine dreiphasige elektrische Last 40 angeschlossen, bei der es sich beispielsweise um ein internes Bordnetz des Schienenfahrzeugs 10 oder um eine oder mehrere Antriebskomponenten des Schienenfahrzeugs 10 handeln kann. Solche von dem Pulswechselrichter 20 gespeiste Antriebskomponenten sind beispielsweise ein oder mehrere Antriebsmotoren, insbesondere ein Drehstrom-Synchron- oder ein oder mehrere Drehstrom-Asynchronmotoren.

Zwischen die dreiphasige elektrische Last 40 und den Pulswechselrichter 20 sind eine Schalteinrichtung 50, eine Filtereinrichtung 60 und eine Strommesseinrichtung 70 geschaltet.

Bei dem Ausführungsbeispiel gemäß Figur 1 besteht die Filtereinrichtung 60 aus drei Kondensatoren C1, C2 und C3 sowie drei Induktivitäten L1, L2 und L3. Die Kondensatoren sind in einer Dreieck-Verschaltung dargestellt. Die Filterkondensatoren können alternativ jedoch ebenso in einer Stern-Verschaltung oder anders verschaltet sein.

Bei dem Ausführungsbeispiel gemäß Figur 1 weist die Strommesseinrichtung 70 drei Messmodule 71, 72 und 73 auf, die dazu ausgelegt sind, die Phasenströme I1, I2 und I3 in den Phasenleitern 22a, 22b und 22c sowohl im Last- als auch im Leerlaufbetrieb des Pulswechselrichters 20 messen können.

Zur Ansteuerung des Pulswechselrichters 20 ist eine Steuereinrichtung 120 vorgesehen. Die Steuereinrichtung 120 umfasst eine Recheneinrichtung 121 und einen Speicher 122. In dem Speicher 122 ist ein Steuerprogrammmodul SPM abgespeichert, das bei Ausführung durch die Recheneinrichtung 121 die Arbeitsweise der Steuereinrichtung 120 vorgibt.

Die Steuereinrichtung 120 bzw. deren Steuerprogrammmodul SPM sind derart ausgestaltet, dass die Steuereinrichtung 120 den Pulswechselrichter 20 mit einem Steuersignal ST ansteuert, das die Sollfrequenz fs der Ausgangswechselspannungen U12, U23 und U13, die zwischen den Phasenleitern 22a, 22b und 22c anliegen, einstellt.

Die Figur 1 zeigt die Schalteinrichtung 50 im geschlossenen Zustand, in dem die dreiphasige elektrische Last 40 mit dem Pulswechselrichter 20 elektrisch in Verbindung steht und von diesem gespeist wird. Die Figur 1 zeigt also mit anderen Worten den Lastbetrieb des Pulswechselrichters 20. Die Sollfrequenz fs im Lastbetrieb, die auch als Lastfrequenz fl bezeichnet werden kann, liegt vorzugsweise zwischen 1 und 100 Hz und beträgt beispielsweise 50 oder 60 Hz.

Im Lastbetrieb des Pulswechselrichters 20 dient die Filtereinrichtung 60 dazu, eine interne Taktfrequenz, mit der der Pulswechselrichter 20 arbeitet, zu dämpfen, damit die interne Taktfrequenz nicht oder nur möglichst wenig in den Ausgangswechselspannungen U12, U23 und U13 zwischen den Phasenleitern 22a, 22b und 22c auftritt und damit möglichst wenig auf die dreiphasige elektrische Last 40 einwirkt. Die interne Taktfrequenz ist vorzugsweise in der Regel mindestens zehnmal höher als die Sollfrequenz fs und liegt beispielsweise in einem Bereich zwischen 1 kHz und 100 kHz.

In dem Speicher 122 der Steuereinrichtung 120 ist neben dem Steuerprogrammmodul SPM auch ein Kontrollmodul KM abgespeichert, das bei Ausführung durch die Recheneinrichtung 121 eine in der Steuereinrichtung 120 softwaremäßig integrierte Kontrolleinrichtung bildet.

Die Kontrolleinrichtung bzw. das Kontrollmodul KM empfängt von der Schalteinrichtung 50 ein Stellsignal SS, das anzeigt, ob die Schalteinrichtung 50 geschlossen oder geöffnet ist. Ist die Schalteinrichtung 50, wie in der Figur 1 gezeigt, geschlossen, so arbeitet der Pulswechselrichter 20 im Lastbetrieb, wie dies oben erläutert worden ist. In diesem Fall beeinflusst die Kontrolleinrichtung bzw. das Kontrollmodul KM die Arbeitsweise des Steuerprogrammmoduls SPM bzw. die normale Arbeitsweise der Steuereinrichtung 120 und die des Pulswechselrichters 20 vorzugsweise nicht.

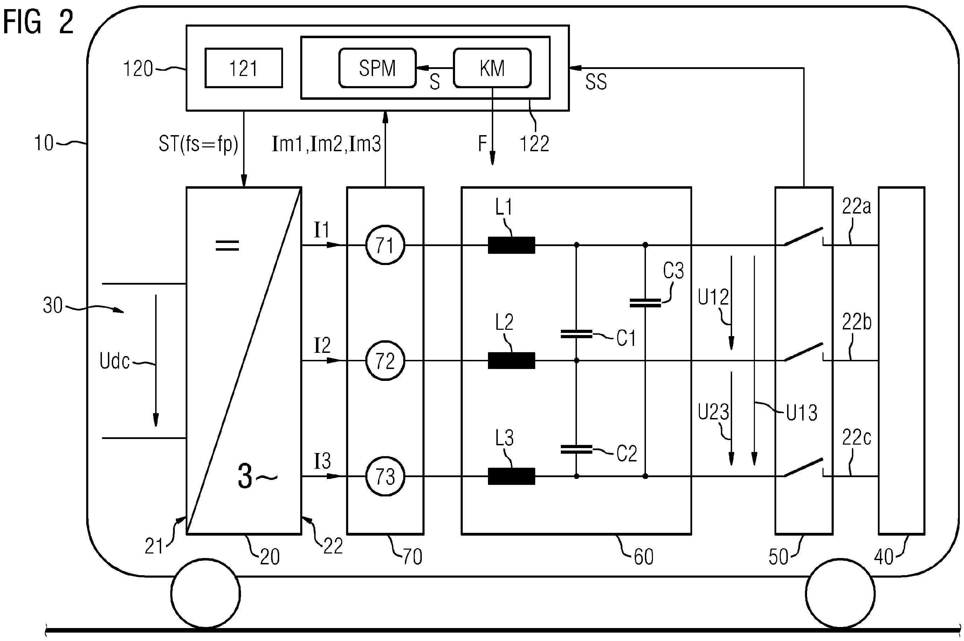

Die Figur 2 zeigt das Schienenfahrzeug 10 gemäß Figur 1, nachdem die Schalteinrichtung 50 geöffnet worden ist und die dreiphasige elektrische Last 40 von dem Pulswechselrichter 20 elektrisch getrennt worden ist. Das Umstellen der Schalteinrichtung 50 und der Übergang vom Lastbetrieb in den Leerlaufbetrieb des Pulswechselrichters 20 wird von dem Kontrollmodul KM anhand des Stellsignals SS erkannt.

Sobald das Kontrollmodul KM feststellt, dass sich der Pulswechselrichter 20 im Leerlaufbetrieb befindet, wirkt sie auf die Arbeitsweise der Steuereinrichtung 120 mittels eines Umstellsignals S ein und führt dadurch dazu, dass die Steuereinrichtung 120 ausgangsseitig ein Steuersignal ST erzeugt, mit dem die Sollfrequenz fs von der für den Lastbetrieb vorgesehenen Lastfrequenz fs auf eine höhere Prüffrequenz fp umgeschaltet wird. Beträgt die normale Lastfrequenz fl beispielsweise 50 Hz, so wird das Kontrollmodul KM die Sollfrequenz fs beispielsweise verdoppeln, also zum Beispiel auf 100 Hz erhöhen, um eine Prüffrequenz fp hervorzurufen, die der doppelten Lastfrequenz fl entspricht.

Darüber hinaus wird das Kontrollmodul KM die von Messmodulen 71, 72 und 73, die die Phasenströme I1, I2 und I3 in den Phasenleitern 22a, 22b und 22c messen, erfassten Leerlaufstrommesswerte IM1, IM2 und IM3 auswerten. Im Rahmen dieser Auswertung wird das Kontrollmodul KM überprüfen, ob der Stromfluss auf der Wechselspannungsseite 22 des Pulswechselrichters 20 eine korrekte Arbeitsweise der Filtereinrichtung 60 anzeigt. Beispielsweise wird das Kontrollmodul KM im Leerlaufbetrieb auf eine korrekte Arbeitsweise der Filtereinrichtung 60 bzw. Funktion der Kondensatoren C1-C3 schließen, wenn die Leerlaufstrommesswerte IM1, IM2 und IM3 jeweils in einem für die jeweilige Prüffrequenz fp vorgegebenen Sollbereich liegen:
Imin ≤ Im1 ≤ Imax
Imin ≤ Im2 ≤ Imax
Imin ≤ Im2 ≤ Imax
wobei Imin einen für die jeweilige Prüffrequenz fp bei ordnungsgemäß arbeitender Filtereinrichtung 60 zu erwartenden Minimalstrom und Imax einen für die jeweilige Prüffrequenz fp bei ordnungsgemäß arbeitender Filtereinrichtung 60 zu erwartenden Maximalstrom angibt. Sind die Leerlaufstrommesswerte zu hoch, so kann dies ein Indiz für einen Ausfall der Kondensatoren beispielsweise durch einen Kurzschluss innerhalb der Kondensatoren sein. Sind die Leerlaufstrommesswerte jedoch zu klein, so kann dies ein Indiz dafür sein, dass einer der Kondensatoren von seinen zugeordneten Phasenleitern abgetrennt worden sein könnte.

Stellt das Kontrollmodul KM fest, dass die Leerlaufstrommesswerte IM1, IM2 und IM3 nicht im vorgegebenen Sollbereich liegen, so erzeugt sie vorzugsweise ein Fehlersignal F, das einen Fehler der Filtereinrichtung 60 anzeigt und eine Wartung der Filtereinrichtung 60 auslöst.

Der Vorteil einer Prüfung der Filtereinrichtung 60 bei einer gegenüber der normalen Sollfrequenz fs = fl im Lastbetrieb erhöhten Prüffrequenz fp besteht darin, dass der Betrag der Impedanz der Kondensatoren C1 bis C3 reduziert wird und damit größere Phasenströme I1-I3 auftreten als bei der kleineren Lastfrequenz fl. Da die Strommesseinrichtung 70 bzw. deren drei Messmodule 71, 72 und 73 auch im Lastbetrieb von Strom durchflossen werden und daher für eine entsprechende Strombelastbarkeit und Messtauglichkeit auch bei hohen Strömen ausgelegt sein müssen bzw. sein sollten, sind diese für sehr kleine Ströme in der Regel nicht sonderlich empfindlich und entsprechend ungenau. Wird nun aber im Leerlaufbetrieb die Sollfrequenz fs erhöht und dadurch auch der Stromfluss durch die Filtereinrichtung 60 erhöht, so wird das Problem der bei sehr kleinen Strömen womöglich nur kleinen Messtauglichkeit der Messmodule 71 bis 73 dadurch reduziert und die Verlässlichkeit des die Filtereinrichtung 60 beschreibenden Prüfergebnisses deutlich verbessert.

Wird im weiteren Betrieb des Pulswechselrichters 20 von dem Kontrollmodul KM festgestellt, dass das Stellsignal SS wieder eine Last des Pulswechselrichters 20 anzeigt, weil die Schalteinrichtung 50 wieder geschlossen worden ist, so wird sie die Sollfrequenz fs des Pulswechselrichters 20 von dem Steuerprogrammmodul SPM wieder reduzieren lassen, und zwar auf die für den Lastbetrieb vorgesehene Lastfrequenz fl, um zu gewährleisten, dass die Last 40 stets nur mit ihrer nominalen Arbeitsfrequenz beaufschlagt wird.

Bei dem Ausführungsbeispiel gemäß den Figuren 1 und 2 ist die Strommesseinrichtung 70 eine separate Komponente, die elektrisch zwischen den Pulswechselrichter 20 und die Filtereinrichtung 60 geschaltet ist und zum Messen der Ströme I1-I3 in den Phasenleitern 22a-22c sowohl im Lastbetrieb als auch im Prüfbetrieb dient bzw. geeignet ist.

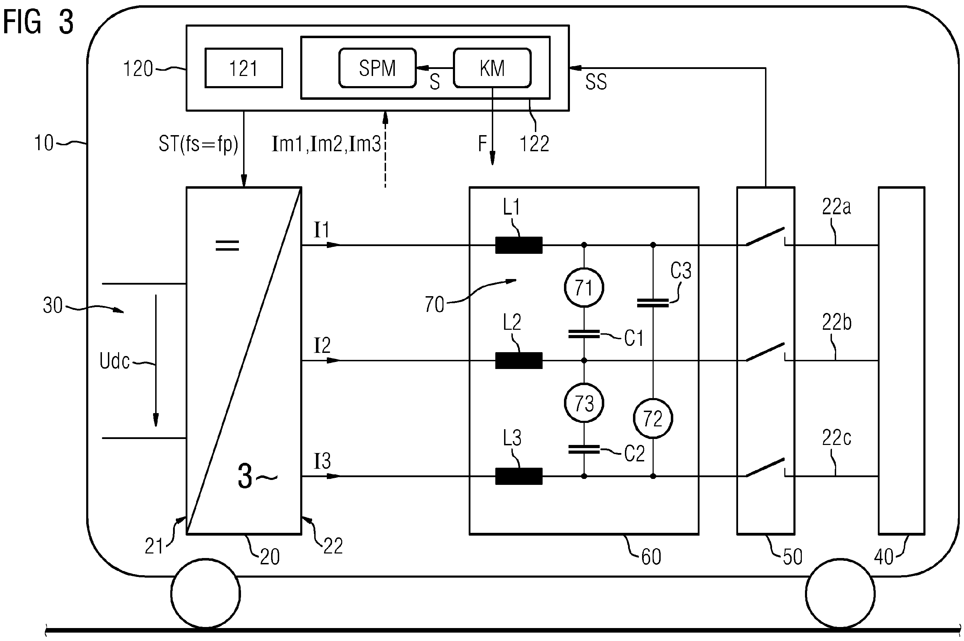

Alternativ können die Messmodule 71, 72 und 73 der Strommesseinrichtung 70 auch in der Filtereinrichtung 60 integriert sein, wie dies beispielhaft in der Figur 3 gezeigt ist. Die drei Messmodule 71, 72 und 73 stehen dann über nicht weiter gezeigte Verbindungsleitungen mit der Steuereinrichtung 120 bzw. dem Kontrollmodul KM in Verbindung, damit das Kontrollmodul KM im Falle eines Leerlaufbetriebs des Pulswechselrichters 20 eine Prüfung der Filtereinrichtung 60 vornehmen kann, wie dies oben beispielhaft im Zusammenhang mit den Figuren 1 und 2 erläutert worden ist.

Im Falle einer Integration der Strommesseinrichtung 70 bzw. deren Messmodule 71 bis 73 in die Filtereinrichtung 60 hinein kann in vorteilhafter Weise erreicht werden, dass die durch die drei Kondensatoren C1, C2 und C3 fließenden Kondensatorströme direkt erfasst und ausgewertet werden können. Dies ermöglicht eine sehr genaue Messung der Kondensatorströme und eine gute Fehlerdetektion gerade bei diesen besonders relevanten Komponenten.

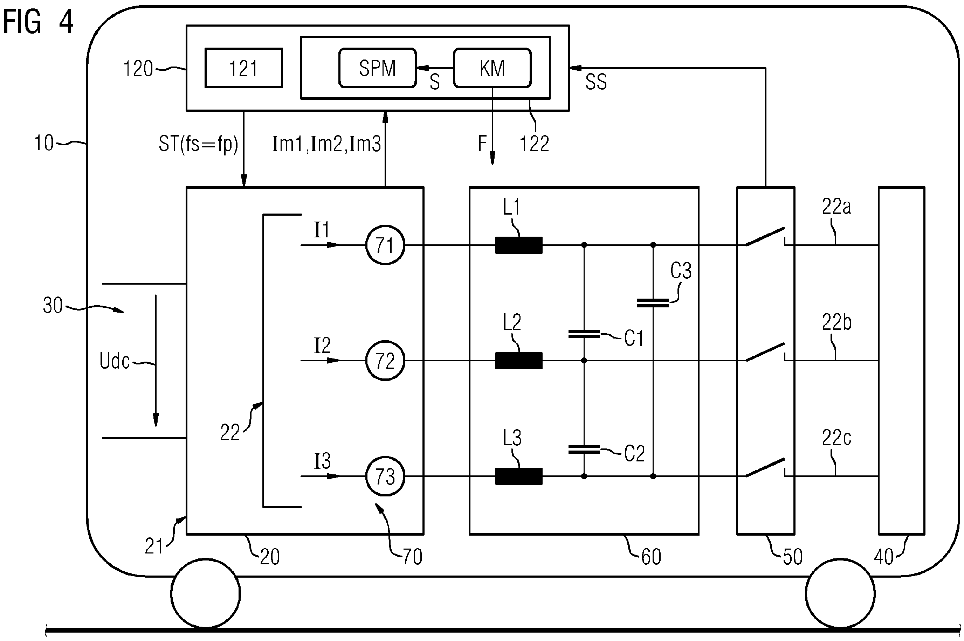

Alternativ ist es möglich, dass die Strommesseinrichtung 70 bereits in dem Pulswechselrichter 20 integriert ist, also der Pulswechselrichter 20 die in den Phasenleitern 22a, 22b und 22c fließenden Ströme selbst erfasst und die entsprechenden Strommesswerte selbst an die Steuereinrichtung 120 übermittelt. Eine solche Ausgestaltung ist beispielhaft in der Figur 4 gezeigt.

Auch ist es möglich, dass die Strommesseinrichtung 70 und die Filtereinrichtung 60 in dem Pulswechselrichter 20 integriert sind, also der Pulswechselrichter 20 die in den Phasenleitern 22a, 22b und 22c fließenden Ströme selbst erfasst und die entsprechenden Strommesswerte selbst an die Steuereinrichtung 120 übermittelt.

In den Figuren 1 bis 4 sind beispielhaft 3AC-Systeme mit drei Phasenleitern ohne Nullleiter dargestellt und beschrieben. Die Ausführungen gelten für andere ein- oder mehrphasige AC-Systeme mit oder ohne Nullleiter entsprechend.

### Bezugszeichenliste

- 10: Schienenfahrzeug
- 20: Pulswechselrichter
- 21: Gleichspannungsseite
- 22: Wechselspannungsseite
- 22a: Phasenleiter
- 22b: Phasenleiter
- 22c: Phasenleiter
- 30: Gleichspannungszwischenkreis
- 40: elektrische Last
- 50: Schalteinrichtung
- 60: Filtereinrichtung
- 70: Strommesseinrichtung
- 71: Messmodul
- 72: Messmodul
- 73: Messmodul
- 120: Steuereinrichtung
- 121: Recheneinrichtung
- 122: Speicher

- C1: Kondensator
- C2: Kondensator
- C3: Kondensator
- f1: Lastfrequenz
- fp: Prüffrequenz
- fs: Sollfrequenz
- F: Fehlersignal
- I1: Phasenstrom
- I2: Phasenstrom
- I3: Phasenstrom
- IM1: Leerlaufstrommesswert
- IM2: Leerlaufstrommesswert
- IM3: Leerlaufstrommesswert
- KM: Kontrollmodul / Kontrolleinrichtung
- L1: Induktivität
- L2: Induktivität
- L3: Induktivität
- S: Umstellsignal
- SPM: Steuerprogrammmodul
- SS: Stellsignal
- ST: Steuersignal
- U12: Ausgangswechselspannung
- U13: Ausgangswechselspannung
- U23: Ausgangswechselspannung
- Udc: Gleichspannung

## Patentansprüche

1. Anordnung für ein Fahrzeug, wobei die Anordnung zumindest umfasst:
- einen ein- oder mehrphasigen Pulswechselrichter (20), der im Betrieb auf Basis einer vorgegebenen internen Taktfrequenz an seiner elektrischen Wechselspannungsseite (22) zumindest eine Ausgangswechselspannung (U12, U23, U13) mit einer vorgegebenen Sollfrequenz (fs) erzeugt, wobei der Pulswechselrichter (20) in einem Lastbetrieb eine Ausgangswechselspannung mit einer vorgegebenen Lastfrequenz (fl) als Sollfrequenz (fs) für eine mit dem Pulswechselrichter (20) verbundene ein- oder mehrphasige elektrische Last (40) bereitstellt, und
- eine zwischen der Wechselspannungsseite (22) des Pulswechselrichters (20) und der Last (40) angeordnete Filtereinrichtung (60), wobei die Filtereinrichtung (60) zumindest einen Kondensator (C1, C2, C3) umfasst und ausgestaltet ist, zumindest die interne Taktfrequenz des Pulswechselrichters (20) der Ausgangswechselspannung (U12, U23, U13) zu filtern,
**dadurch gekennzeichnet, dass**
- die Anordnung ferner eine Kontrolleinrichtung (KM) umfasst, wobei die Kontrolleinrichtung (KM) ausgestaltet ist, in einem Leerlaufbetrieb des Pulswechselrichters (20) die Sollfrequenz (fs) in eine vorgegebene Prüffrequenz (fp) zu ändern, wobei die Prüffrequenz (fp) höher als die Lastfrequenz (fl) ist, zumindest einen bei der Prüffrequenz (fp) auf der Wechselspannungsseite des Pulswechselrichters (20) fließenden Leerlaufstrom zu messen, und mittels des zumindest einen Leerlaufstrommesswerts (Im1, Im2, Im3) eine korrekte Funktion des zumindest einen Kondensators (C1, C2, C3) der Filtereinrichtung (60) zu bestimmen.

2. Anordnung nach Anspruch 1,
**dadurch gekennzeichnet, dass**
die Kontrolleinrichtung (KM) ferner ausgestaltet ist, im Leerlaufbetrieb des Pulswechselrichters (20) auf eine korrekte Funktion des zumindest einen Kondensators (C1, C2, C3) der Filtereinrichtung (60) zu schließen, wenn der Leerlaufstrommesswert (Im1, Im2, Im3) in einem vorgegebenen Sollbereich liegt.

3. Anordnung nach einem der voranstehenden Ansprüche, **dadurch gekennzeichnet, dass**
- die Anordnung ferner eine Schalteinrichtung (50) umfasst, wobei die Schalteinrichtung (50) in einer elektrischen Verbindung zwischen der Filtereinrichtung (60) und der elektrischen Last (40) angeordnet ist, und wobei die Schalteinrichtung (50) ausgestaltet ist, die Last (40) von dem Pulswechselrichter (20) zu trennen, und
- die Kontrolleinrichtung (KM) ferner ausgestaltet ist, in dem Leerlaufbetrieb des Pulswechselrichters (20) die Sollfrequenz (fs) auf die Prüffrequenz (fp) zu ändern, und den zumindest einen Leerlaufstrommesswert (Im1, Im2, Im3) zu bestimmen, wenn die Verbindung mittels der Schalteinrichtung (50) getrennt ist.

4. Anordnung nach einem der voranstehenden Ansprüche,
**dadurch gekennzeichnet, dass**
die Anordnung ferner zumindest eine auf der Wechselspannungsseite (22) des Pulswechselrichters (20) angeordnete Strommesseinrichtung (70) umfasst, wobei die zumindest eine Strommesseinrichtung (70) im Leerlaufbetrieb den zumindest einen Leerlaufstrommesswert (Im1, Im2, Im3) erzeugt.

5. Anordnung nach Anspruch 4,
**dadurch gekennzeichnet, dass**
die zumindest eine Strommesseinrichtung (70) in einer elektrischen Verbindung zwischen dem Pulswechselrichter (20) und der Filtereinrichtung (60) angeordnet ist.

6. Anordnung nach einem der voranstehenden Ansprüche,
**dadurch gekennzeichnet, dass**
die Kontrolleinrichtung (KM) auf einen Leerlaufbetrieb des Pulswechselrichters (20) schließt, wenn der zumindest eine Leerlaufstrommesswerts (Im1, Im2, Im3) betragsmäßig einen vorgegebenen Mindestwert erreicht oder diesen unterschreitet.

7. Anordnung nach einem der Ansprüche 4 bis 6,
**dadurch gekennzeichnet, dass**
die zumindest eine Strommesseinrichtung (70) einen Kondensatorstrom durch den zumindest einen Kondensator (C1, C2, C3) der Filtereinrichtung (60) misst.

8. Anordnung nach einem der voranstehenden Ansprüche,
**dadurch gekennzeichnet, dass**
die Kontrolleinrichtung (KM) in eine Steuereinrichtung (120) des Pulswechselrichters (20) integriert ist.

9. Anordnung nach einem der voranstehenden Ansprüche, **dadurch gekennzeichnet, dass**
- die Ausgangsspannung des Pulswechselrichters (20) an der elektrischen Wechselspannungsseite (22) im Lastbetrieb eine Sollfrequenz (fs) zwischen 1 und 100 Hz aufweist, und
- die interne Taktfrequenz des Pulswechselrichters (20) mindestens zehnmal höher als die Sollfrequenz (fs) im Lastbetrieb ist.

10. Fahrzeug (10),
**gekennzeichnet durch**
zumindest eine Anordnung nach einem der Ansprüche 1 bis 9.

11. Fahrzeug (10) nach Anspruch 10,
**dadurch gekennzeichnet, dass**
- es einen Gleichspannungszwischenkreis (30) aufweist, der mit einer elektrischen Gleichspannungsseite (21) des Pulswechselrichters (20) verbunden ist, und
- als elektrische Last (40) eine Antriebskomponente des Fahrzeugs (10) oder ein Bordnetz des Fahrzeugs (10) von dem Gleichspannungszwischenkreis (30) über den Pulswechselrichter (20) mit elektrischer Energie speisbar ist.

12. Fahrzeug (10) nach Anspruch 10 oder 11,
**dadurch gekennzeichnet, dass**
es als ein Schienenfahrzeug ausgestaltet ist.

13. Verfahren zum Betreiben einer Anordnung für ein Fahrzeug (10), wobei die Anordnung einen ein- oder mehrphasigen Pulswechselrichters (20) umfasst und wobei der Pulswechselrichter (20) auf Basis einer vorgegebenen internen Taktfrequenz an einer elektrischen Wechselspannungsseite (22) zumindest eine Ausgangswechselspannung (U12, U23, U13) mit einer vorgegebenen Sollfrequenz (fs) erzeugt,
- wobei von dem Pulswechselrichter (20) in einem Lastbetrieb eine Ausgangswechselspannung mit einer vorgegebenen Lastfrequenz (fl) als Sollfrequenz (fs) für eine mit dem Pulswechselrichter (20) verbundene ein- oder mehrphasige elektrische Last (40) bereitgestellt wird, und
- wobei mittels einer zwischen der elektrischen Wechselspannungsseite (22) des Pulswechselrichters (20) und der Last (40) angeordneten Filtereinrichtung (60) zumindest die interne Taktfrequenz des Pulswechselrichters (20) gefiltert wird,
**dadurch gekennzeichnet, dass**
- in einem Leerlaufbetrieb des Pulswechselrichters (20) von einer Kontrolleinrichtung der Anordnung die Sollfrequenz (fs) in eine Prüffrequenz (fp) geändert wird, wobei die Prüffrequenz (fp) höher als die Lastfrequenz (fl) ist, zumindest ein bei der Prüffrequenz (fp) auf der Wechselspannungsseite des Pulswechselrichters (20) fließender Leerlaufstrom gemessen wird, und mittels des zumindest einen Leerlaufstrommesswerts (Im1, Im2, Im3) eine korrekte Funktion des zumindest einen Kondensators (C1, C2, C3) der Filtereinrichtung (60) bestimmt wird.

14. Verfahren nach Anspruch 13,
**dadurch gekennzeichnet, dass**
- eine Schalteinrichtung (50) der Anordnung in einer elektrischen Verbindung zwischen der Filtereinrichtung (60) und der elektrischen Last (40) angeordnet ist, wobei von der Schalteinrichtung die Last (40) von dem Pulswechselrichter (20) getrennt wird, und
- von der Kontrolleinrichtung (KM) auf den Leerlaufbetrieb des Pulswechselrichters (20) geschlossen wird, die Sollfrequenz (fs) auf die Prüffrequenz (fp) geändert wird, und der zumindest eine Leerlaufstrommesswert (Im1, Im2, Im3) bestimmt wird, wenn die Verbindung mittels der Schalteinrichtung (50) getrennt ist.

15. Verfahren nach Anspruch 13 oder 14,
**dadurch gekennzeichnet, dass**
bei einem mehrphasigen Pulswechselrichter (20) und einer Filtereinrichtung mit zumindest einem Kondensator (C1, C2, C3) je Phase der Ausgangswechselspannung die korrekte Funktion der Kondensatoren (C1, C2, C3) mittels eines Vergleichs der Leerlaufstrommesswerte (Im1, Im2, Im3) bestimmt wird.
